# EUROPEAN PATENT APPLICATION

(11) **EP 4 818 831 A1**
(43) Date of publication of application: **07.10.2026**
(21) Application number: 26166220.9
(22) Date of filing: 19.03.2026
(51) Int. Cl.: G05B 19/409, G05B 19/408

(54) **PROCESSING APPARATUS, SUBSTRATE PROCESSING APPARATUS, PROCESSING METHOD, METHOD OF MANUFACTURING SEMICONDUCTOR DEVICE AND PROGRAM**

(30) Priority: 28.03.2025 JP 2025057226
(71) Applicant: Kokusai Electric Corp., Tokyo 100-0004 (JP)
(72) Inventor: YAMAOKA, Yuji, Toyama-shi, 939-2393 (JP); SEKI, Takatoshi, Toyama-shi, 939-2393 (JP)
(74) Representative: Verscht, Thomas Kurt Albert

(57) **Abstract**

It is possible to save storage capacity by reducing a file size of a recipe. There is provided a technique that includes: a display for a recipe constituted by steps including process conditions containing at least one item and at least one setting value therefor; a controller for: checking, for each step, a flag indicating whether a setting value is to be stored; and when a flag in a specified step is set to be valid, comparing a setting value in the specified step with a setting value in a most recent preceding step whose flag is set to be valid; and switching the flag in the specified step to invalid when it is equal to the setting value in the most recent preceding step; and a first memory storing at least an item and a setting value therefor in a step whose flag is set to be valid.

## Description

### [Technical Field]

The present disclosure relates to a processing apparatus, a substrate processing apparatus, a processing method, a method of manufacturing a semiconductor device and a program.

### [Related Art]

A recipe used in a manufacturing process of a semiconductor device may be edited to process a substrate (see, for example, Patent Document 1).

### [Related Art Document]

### [Patent document]

Patent Document 1: International Patent Publication No. 2019/186649.

### [Disclosure]

### [Technical Problem]

According to the present disclosure, there is provided a technique capable of suppressing (or reducing) consumption of storage capacity by reducing a file size of a recipe when storing the recipe.

### [Technical Solution]

According to an embodiment of the present disclosure, there is provided a technique that includes: a display configured to be capable of displaying, on a screen, a recipe constituted by a plurality of steps in which process conditions for a substrate processing are defined, wherein the process conditions contain at least one item and at least one setting value therefor; a controller configured to be capable of: checking, for each of the plurality of steps, a flag indicating whether a setting value in each step is to be stored; and when a flag in a specified step is set to be valid, comparing a setting value in the specified step with a setting value in a most recent preceding step whose flag is set to be valid; and switching the flag in the specified step to invalid when the setting value in the specified step is equal to the setting value in the most recent preceding step; and a first memory configured to store at least an item and a setting value therefor in a step whose flag is set to be valid, among setting values in the plurality of steps.

### [Advantageous Effects]

According to some embodiments of the present disclosure, it is possible to suppress (or reduce) a consumption of a storage capacity by reducing a file size of a recipe when storing the recipe.

### [Brief Description of Drawings]

FIG. 1 is a diagram schematically illustrating a perspective view of an example of a substrate processing apparatus according to one or more embodiments of the present disclosure.
FIG. 2 is a diagram schematically illustrating a cross-section of the substrate processing apparatus according to the embodiments of the present disclosure when viewed from side.
FIG. 3 is a block diagram schematically illustrating an example of a functional configuration of a control apparatus and related components of the substrate processing apparatus according to the embodiments of the present disclosure.
FIG. 4A is a diagram schematically illustrating an example of recipe information temporarily stored in a RAM (Random Access Memory), and FIG. 4B is a diagram schematically illustrating an example of recipe information stored in a memory.
FIG. 5 is a diagram schematically illustrating an example of a recipe editing screen according to the embodiments of the present disclosure.
FIG. 6 is a flow chart schematically illustrating an example of a flag switching process for a recipe.

### [Detailed Description]

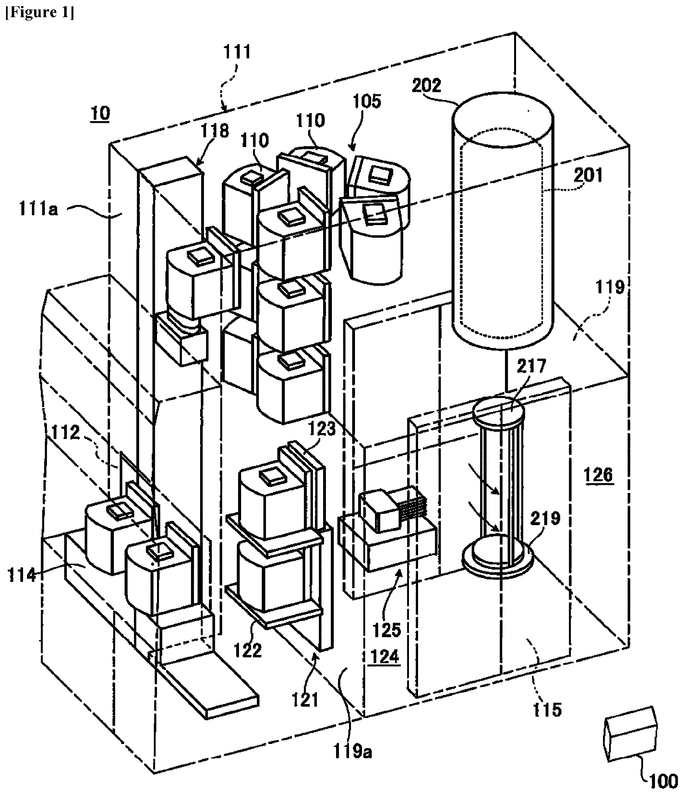

Hereinafter, one or more embodiments (also simply referred to as "embodiments") according to the technique of the present disclosure will be described mainly with reference to FIGS. 1 to 6. The drawings used in the following descriptions are all schematic. For example, a relationship between dimensions of each component and a ratio of each component shown in the drawing may not always match the actual ones. Further, even between the drawings, the relationship between the dimensions of each component and the ratio of each component may not always match. In addition, components the same or substantially the same as components described in the drawings are denoted by the same or substantially the same reference numerals, and redundant descriptions related thereto will be omitted. In addition, the technique of the present disclosure is not limited to the embodiments described below. That is, the technique of the present disclosure may be appropriately modified in various ways without departing from the scope thereof.

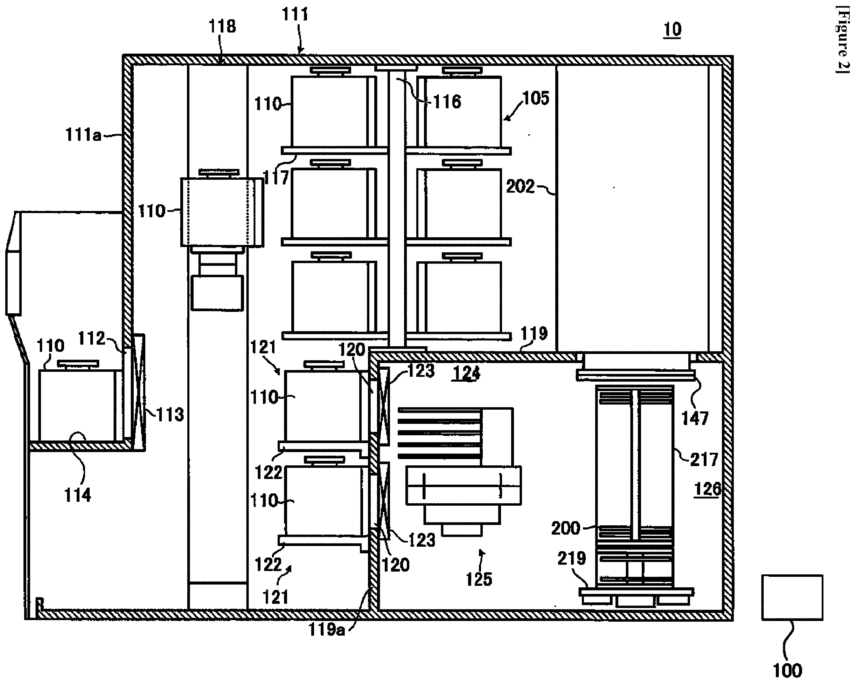

First, with reference to FIGS. 1 and 2, an outline of a substrate processing apparatus 10 according to the present embodiments will be described.

FIG. 1 is a diagram schematically illustrating a perspective view of an example of the substrate processing apparatus 10 according to the present embodiments, and FIG. 2 is a diagram schematically illustrating a cross-section of the substrate processing apparatus 10 according to the present embodiments when viewed from side. In FIGS. 1 and 2, a vertical type substrate processing apparatus is shown as an example of the substrate processing apparatus 10, and a semiconductor wafer made of a material such as silicon is shown as an example of a substrate (that is, a wafer 200 described later) to be processed in the substrate processing apparatus 10. In the present specification, the term "wafer" may refer to "a wafer itself", or may refer to "a wafer and a stacked structure (aggregated structure) of a predetermined layer (or layers) or a film (or films) formed on a surface of the wafer". In the present specification, the term "a surface of a wafer" may refer to "a surface of a wafer itself", or may refer to "a surface of a predetermined layer (or a predetermined film) formed on a wafer". Thus, in the present specification, the term "forming a predetermined layer (or a film) on a wafer" may refer to "forming a predetermined layer (or a film) directly on a surface of a wafer itself", or may refer to "forming a predetermined layer (or a film) on a surface of another layer (or another film) formed on a wafer". In the present specification, the terms "substrate" and "wafer" may be used as substantially the same meaning.

As shown in FIGS. 1 and 2, the substrate processing apparatus 10 includes a housing 111. A pod loading/unloading port 112 is provided at a front wall 111a of the housing 111 so as to communicate between an inside (inner portion) and an outside (outer portion) of the housing 111. The pod loading/unloading port 112 can be opened or closed by a front shutter (which is a structure capable of opening and closing the pod loading/unloading port 112) 113. A loading port (which is a loading port shelf, that is, a transfer table for a substrate transfer container) 114 is provided in front of the pod loading/unloading port 112.

For example, a pod 110 is configured as a sealed type substrate transfer container. The pod 110 may be transferred (loaded) into and placed on the loading port 114 by an in-process transfer apparatus (not shown) and may be transferred (unloaded) out of the loading port 114 by the in-process transfer apparatus.

A rotatable pod shelf (which is a storage shelf for the substrate transfer container) 105 is provided in the housing 111 to be located over a substantially center portion of the housing 111 in a front-rear direction. The rotatable pod shelf 105 is configured such that a plurality of pods including the pod 110 can be stored (or placed) on the rotatable pod shelf 105. Hereinafter, the plurality of pods including the pod 110 may also be simply referred to as "pods 110". The rotatable pod shelf 105 includes a plurality of shelf plates (which are placement shelves for the substrate transfer container) 117 arranged in a multistage manner. Each of the plurality of shelf plates 117 is configured to accommodate at least one among the pods 110.

A pod opener (which is a structure capable of opening and closing a lid of the substrate transfer container) 121 is provided below the rotatable pod shelf 105. The pod opener 121 is provided with a configuration capable of accommodating the pod 110 thereon and opening and closing a lid of the pod 110.

A pod transfer structure (which is a container transfer structure) 118 is provided among the loading port 114, the rotatable pod shelf 105 and the pod opener 121. The pod transfer structure 118 is configured such that the pod 110 can be transferred among the loading port 114, the rotatable pod shelf 105 and the pod opener 121.

A sub-housing 119 is provided below the substantially center portion of the housing 111 in the front-rear direction to extend toward a rear end of the substrate processing apparatus 10. A pair of wafer loading/unloading ports (substrate loading/unloading ports) 120 through which the wafer 200 serving as the substrate is loaded into or unloaded out of the sub-housing 119 is provided at a front wall 119a of the sub-housing 119.

The pod opener 121 includes: a placement table 122 where the pod 110 is placed thereon; and an opening/closing structure (attaching/detaching structure) 123 capable of opening (or detaching) or closing (or attaching) the lid of the pod 110. The pod opener 121 is configured such that a wafer entrance of the pod 110 is opened or closed by opening or closing the lid of the pod 110 placed on the placement table 122 by the opening/closing structure 123.

The sub-housing 119 defines a transfer chamber 124 fluidically isolated from a space (hereinafter, also referred to as a "pod transfer space") in which the pod transfer structure 118 or the rotatable pod shelf 105 is provided. A wafer transfer structure (which is a substrate transfer structure) 125 is provided at a front region of the transfer chamber 124. A predetermined number of wafers (for example, as shown in FIG. 2, five wafers) placed on the wafer transfer structure 125 can be moved linearly in a horizontal direction, can be rotated in the horizontal direction and can be elevated or lowered in a vertical direction. The wafer transfer structure 125 is configured such that the wafer 200 can be loaded into or unloaded out of a boat (which is a substrate retainer or a substrate support) 217.

In a rear region of the transfer chamber 124, a standby space 126 where the boat 217 is accommodated in standby is provided, and a process furnace 202 such as a vertical type process furnace is provided above the standby space 126. In addition, the process furnace 202 may also be referred to as a "process vessel" in which the wafer 200 is processed. For example, a process chamber 201 is defined by the process furnace 202.

Subsequently, an operation of the substrate processing apparatus 10 will be described.

When the pod 110 is supplied to the loading port 114, the pod loading/unloading port 112 is opened by the front shutter 113 Then, the pod 110 placed on the loading port 114 is transferred (loaded) into the housing 111 through the pod loading/unloading port 112 by the pod transfer structure 118, and is placed on a designated shelf plate among the plurality of shelf plates 117 of the rotatable pod shelf 105. The pod 110 is temporarily stored at the rotatable pod shelf 105. Then, the pod 110 is transferred from the designated shelf plate among the plurality of shelf plates 117 to the pod opener 121 and is placed on the placement table 122 by the pod transfer structure 118. Alternatively, the pod 110 may be transferred directly from the loading port 114 to the placement table 122.

When an end surface of the pod 110 placed on the placement table 122 is pressed against an opening edge of the wafer loading/unloading port 120 of the front wall 119a of the sub-housing 119, the opening/closing structure 123 detaches the lid of the pod 110 and the wafer entrance of the pod 110 is opened.

When the pod 110 is opened by the pod opener 121, the wafer 200 is then taken out from the pod 110 by the wafer transfer structure 125. Then, by the wafer transfer structure 125, the wafer 200 is transferred (or loaded) into the standby space 126, and loaded (or charged) into the boat 217.

When a predetermined number of wafers including the wafer 200 are charged into the boat 217, a furnace opening of the process furnace 202 closed by a furnace opening shutter 147 is opened by the furnace opening shutter 147. Subsequently, the boat 217 is elevated by a boat elevator 115 such that the boat 217 is loaded (inserted) into the process chamber 201.

After the boat 217 is loaded, the furnace opening is airtightly closed by a seal cap 219. Further, according to the present embodiments, at such a timing (that is, after the boat 217 is loaded), a purge step (also referred to as a "pre-purge step") of replacing an atmosphere (inner atmosphere) of the process chamber 201 with an inert gas may be performed.

The process chamber 201 is vacuum-exhausted by a vacuum pump (not shown) such that a pressure (inner pressure) of the process chamber 201 reaches and is maintained at a desired pressure (vacuum degree). In addition, the process chamber 201 is heated to a predetermined temperature by a heater (not shown) such that a desired temperature distribution of the process chamber 201 is obtained.

Further, a process gas is supplied from a process gas supply source (not shown). That is, the process gas whose flow rate is controlled to a predetermined flow rate is supplied. The process gas comes into contact with a surface of the wafer 200 while flowing through the process chamber 201. Thereby, a predetermined processing such as a substrate processing described later is performed on the surface of the wafer 200. In addition, the process gas after being subject to a chemical reaction in the predetermined processing is exhausted from the process chamber 201 by a gas exhaust structure (which is a gas exhauster) (not shown). In the present specification, the term "process gas" refers to a gas supplied into the process chamber 201. The same also applies to the following description.

After a predetermined process time has elapsed, the inert gas is supplied from an inert gas supply source (not shown). Thereby, the inner atmosphere of the process chamber 201 is replaced with the inert gas, and the inner pressure of the process chamber 201 is returned to a normal pressure (after-purge step). Then, the boat 217 is lowered by the boat elevator 115 through the seal cap 219. In the present specification, the term "process time" refers to a time duration of continuously performing a process related thereto. The same also applies to the following description.

After the wafer 200 is processed, the wafer 200 and the pod 110 are transferred (unloaded) out of the housing 111 in an order reverse to that of loading the wafer 200 and the pod 110 into the housing 111 described above. Then, another wafer (which is unprocessed) 200 is further loaded into the boat 217, and a batch processing for another wafer 200 is performed. For example, the pod 110 accommodating the wafer 200 (which is processed) may be temporarily placed on the rotatable pod shelf 105, then transferred from the designated shelf plate among the plurality of shelf plates 117 to the loading port 114 by the pod transfer structure 118, and then transferred to the outside of the housing 111.

According to the present embodiments, as shown in FIGS. 1 and 2, the substrate processing apparatus 10 includes a control apparatus (which is a control structure) 100, and the control apparatus 100 is configured to control the substrate processing apparatus 10. The control apparatus 100 may be provided (embedded) in the substrate processing apparatus 10, or may be provided outside the substrate processing apparatus 10 in a manner accessible thereto.

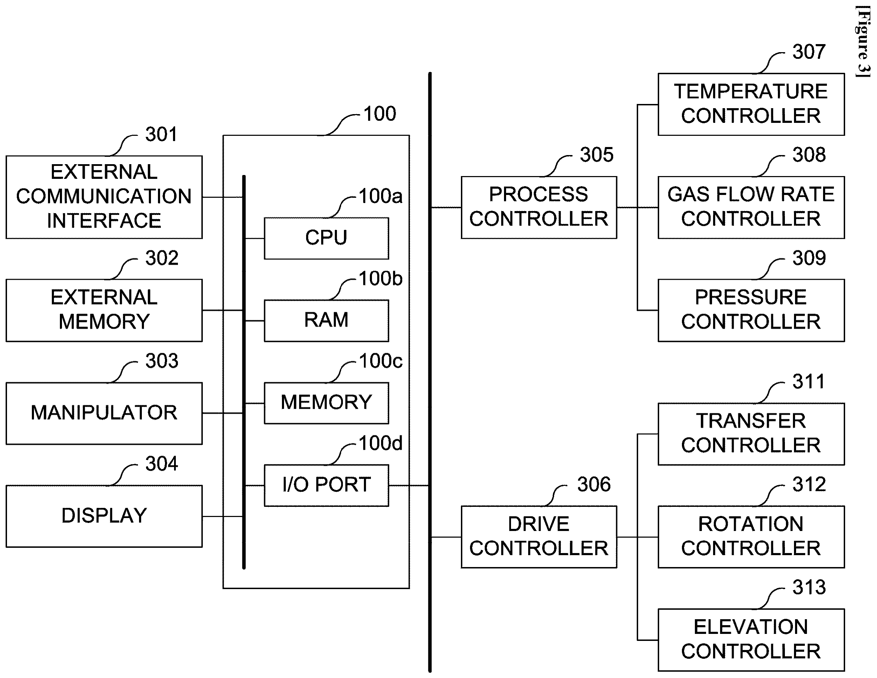

Subsequently, with reference to FIG. 3, a configuration of a control system of the substrate processing apparatus 10 according to the present embodiments will be described. FIG. 3 is a block diagram schematically illustrating an example of a functional configuration of the control apparatus 100 of the substrate processing apparatus 10 according to the present embodiments.

As shown in FIG. 3, the substrate processing apparatus 10 includes the control apparatus (which is a main controller or a primary controller) 100, an external communication interface 301, an external memory 302, a manipulator 303, a display (which is a display structure) 304, a process controller 305 and a drive controller 306.

For example, the control apparatus 100 includes a CPU (Central Processing Unit) 100a serving as a controller, a RAM (Random Access Memory) 100b serving as a second memory, a memory 100c serving as a first memory and an I/O port (input/output port) 100d. The RAM 100b serves as an example of a volatile memory.

The control apparatus 100 is connected to the manipulator 303 and the display 304, and also connected to the process controller 305 and the drive controller 306 via the I/O port 100d. Since the control apparatus 100 is electrically connected to each of the process controller 305 and the drive controller 306 via the I/O port 100d, for example, each piece of data can be transmitted or received and each file can be downloaded or uploaded between the control apparatus 100 and each of the process controller 305 and the drive controller 306.

The control apparatus 100 is connected to an external host computer (not shown) via the external communication interface 301. Therefore, even when the substrate processing apparatus 10 is installed in a clean room, the host computer can be disposed at a location such as an office outside the clean room. In addition, the external memory 302 (which serves as a mounting structure on or from which a recording medium such as a USB (Universal Serial Bus) memory is installed or removed) is connected to the control apparatus 100.

For example, the manipulator 303 is implemented as a configuration which is integrated with the display 304 as a single structure or which is connected to the display 304 via a connector such as a video cable. For example, the display 304 is configured as a liquid crystal display panel. Various operation screens for operating the substrate processing apparatus 10 can be displayed on the display 304. As one of the operation screens, a recipe editing screen 12 for the substrate processing is provided. The recipe editing screen 12 is provided to control a process system controlled by the process controller 305 and a drive system controlled by the drive controller 306. The display 304 is configured to be capable of displaying, on the recipe editing screen 12, a recipe constituted by a plurality of steps in which process conditions for the substrate processing are defined. For example, the process conditions may include at least one item and at least one setting value therefor.

The manipulator 303 is configured to be capable of editing the recipe displayed on the display 304 via the recipe editing screen 12. For example, the manipulator 303 is configured to be capable of editing a flag (that is, a state of the flag) and the setting value for each item in each step by operating the recipe editing screen 12. In other words, the manipulator 303 is configured to be capable of switching the flag (the state of the flag) displayed in the recipe. According to the present embodiments, the term "flag" indicates whether an item in a step related thereto and a setting value for the item in the step related thereto are to be saved (that is, to be stored) into the memory 100c. For example, when the flag for the item in the step related thereto is set to be valid (that is, when the flag is set to be "ON" or "1"), it indicates that the item in the step related thereto and the setting value for the item in the step related thereto are to be saved. On the other hand, when the flag for the item in the step related thereto is set to be invalid (that is, when the flag is set to be "OFF" or "0"), it indicates that the item in the step related thereto and the setting value for the item in the step related thereto are not to be saved.

The CPU 100a is configured to be capable of controlling the display 304 such that a displayed image of the setting value for the recipe edited by operating the manipulator 303 can be switched (or toggled). In addition, the CPU 100a is configured to control the display 304 such that the flag (that is, the state of the flag) for the setting value can be switched in accordance with the setting value for the recipe edited by operating the manipulator 303. In addition, the CPU 100a is configured to change the setting value in each step that comes after a switched step (i.e., a step whose flag is switched) and before a next valid step (i.e., a step which comes after the switched step and whose setting value is set to be valid) to become equal to the setting value edited by operating the manipulator 303, and to set a flag in aforementioned each step to be invalid (that is, disabled). In addition, the CPU 100a is configured to temporarily store, in the RAM 100b, the setting value in each step, including each item whose flag is set to be invalid and the setting value therefor, and to control the display 304 to display the recipe including each item and the setting value therefor (which are temporarily stored) on the recipe editing screen 12. As a result, it is possible to easily edit the recipe on the recipe editing screen 12. In addition, since the CPU 100a is configured to control the display 304 by operating the manipulator 303, it is possible to reduce the load on the manipulator 303 and the display 304 and it is also possible to obtain a smooth flow of operations. The CPU 100a is further configured to be capable of controlling the display 304 such that a displayed image of the setting value in the step edited by operating the manipulator 303 is different from a displayed image of the setting value in another step which is not edited. Specifically, for example, the CPU 100a controls the display 304 to change a background color or text color of a cell (where the setting value in the edited step is displayed) to a color different from a background color or text color of a cell (where the setting value in the another step which is not edited) is displayed). For example, the CPU 100a controls the display 304 to display the setting value (which is edited) on the recipe editing screen 12 in a manner that it is possible to easily identify that the setting value is edited, for example, by adding a thick border around the cell for the setting value in the edited step, or by adding a border of a different color around the cell for the setting value in the edited step than around the cell for the setting value in another step (which is not edited). As a result, it is possible to easily identify the setting value for the item in the edited step.

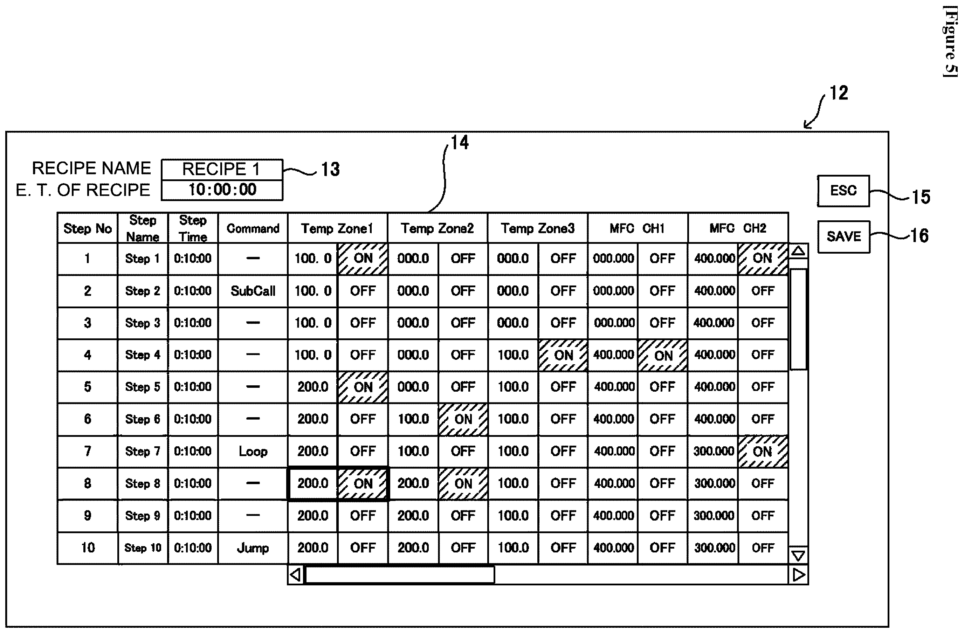

The CPU 100a is further configured to be capable of controlling the display 304 to switch (or toggle) a displayed image of the flag (the state of the flag) for the recipe switched by operating the manipulator 303. Specifically, the CPU 100a is configured to be capable of controlling the display 304 to switch the displayed image of the flag from invalid (that is, a display indicating that the flag is set to be invalid) to valid (that is, a display indicating that the flag is set to be valid) when the flag is switched from invalid to valid by operating the manipulator 303. In addition, the CPU 100a is configured to be capable of controlling the display 304 to switch the displayed image of the flag from valid (that is, the display indicating that the flag is set to be valid) to invalid (that is, the display indicating that the flag is set to be invalid) when the flag is switched from valid to invalid by operating the manipulator 303. In such an operation, the CPU 100a is configured to be capable of: changing the setting value whose flag is switched to invalid; and the setting value in each step that comes after the switched step (i.e., the step whose flag is switched to invalid) and before a next valid step (i.e., a step which comes after the switched step and whose flag is set to be valid) to become equal to the setting value in a previous valid step (i.e., a step which comes before the switched step and whose flag is set to be valid). In a manner described above, when the flag is switched to invalid, it is possible to automatically change the setting value in each step between the switched step and the next valid step. Thereby, it is possible to easily edit the recipe on the recipe editing screen 12. In addition, since the CPU 100a is configured to control the display 304 by operating the manipulator 303, it is possible to reduce the load on the manipulator 303 and the display 304. The CPU 100a is further configured to be capable of controlling the display 304 such that a displayed image of the flag in the step edited by operating the manipulator 303 is different from a displayed image of the flag in another step which is not edited. Specifically, for example, the CPU 100a controls the display 304 to change a background color or text color of a cell (where the flag in the edited step is displayed as, for example, "ON" or "OFF") to a color different from a background color or text color of a cell (where the flag in another step which is not edited is displayed as, for example, "ON" or "OFF"). For example, as shown in FIG. 5, the CPU 100a controls the display 304 to display the cell (where, for example, "ON" or "OFF" is displayed) in the edited step on the recipe editing screen 12 in a manner that it is possible to easily identify that the flag is edited, for example, by adding a thick border around the cell for the flag in the edited step, or by adding a border of a different color around the cell for the flag in the edited step than around the cell for the flag in another step which is not edited. As a result, it is possible to easily identify the flag (that is, the state of the flag) for the item in the edited step.

For example, the manipulator 303 outputs the information displayed on the display 304 to a component (device) such as the USB memory inserted in the external memory 302. The manipulator 303 accepts (or receives) input data (input instruction) from the operation screen displayed on the display 304 and transmits the input data to the control apparatus 100. Further, the manipulator 303 is configured to receive an instruction (control instruction) to execute an appropriate substrate processing recipe (also referred to as a "process recipe") among recipes loaded (or deployed) in the RAM 100b or recipes stored in the memory 100c, and is further configured to transmit the instruction to the control apparatus 100. For example, the manipulator 303 and the display 304 may be configured as a touch panel. According to the present embodiments, the manipulator 303 and the display 304 are provided separately from the control apparatus 100. However, the manipulator 303, the display 304 and the control apparatus 100 may be integrated into a single structure.

The process controller 305 includes controllers (sub-controllers) such as a temperature controller 307, a gas flow rate controller 308 and a pressure controller 309. That is, each of the temperature controller 307, the gas flow rate controller 308 and the pressure controller 309 may also be referred to as the "sub-controller", and is electrically connected to the process controller 305. Thereby, for example, each piece of data can be transmitted or received and each file can be downloaded or uploaded between the process controller 305 and each sub-controller. In addition, while the process controller 305 and each sub-controller (that is, the temperature controller 307, the gas flow rate controller 308 and the pressure controller 309) are illustrated separately, the process controller 305 and each sub-controller may be integrated into a single structure.

The temperature controller 307 is configured to control a process temperature based on the setting values for a plurality of zones defined (or set) in the recipe and measured values detected by a plurality of temperature sensors (not shown) respectively installed in the plurality of zones. Specifically, the temperature controller 307 is configured to adjust a temperature (inner temperature) of the process chamber 201 or a temperature of the wafer 200 by controlling temperatures of heaters (not shown) respectively provided corresponding to the zones. In the present specification, the term "process temperature" refers to the "temperature of the wafer 200" or the "inner temperature of the process chamber 201".

Each zone refers to an area (or a region) obtained by dividing the process chamber 201 into a plurality of areas (regions) in a height direction. According to the present embodiments, for example, the process chamber 201 is divided into five areas. In addition, the number of the zones is not limited to five, and the process chamber 201 may be divided into zones other than five zones depending on a configuration of an apparatus (that is, the substrate processing apparatus 10). In addition, the heaters may be provided corresponding to the zones, respectively. According to the present embodiments, for example, five heaters are provided corresponding to the five zones. The temperature of the wafer 200 or the inner temperature of the process chamber 201 is controlled by the five heaters.

The gas flow rate controller 308 is configured to adjust a flow rate of the gas (which is supplied into the process chamber 201) to a desired flow rate based on the setting value defined (or set) in the recipe and measured values detected by a gas flow rate sensor (not shown). Specifically, the gas flow rate controller 308 is configured to control an opening and closing operation of a valve in accordance with an opening/closing state of the valve defined (or set) in the recipe. The gas flow rate controller 308 is configured to adjust the flow rate of the gas supplied into the process chamber 201 by controlling the opening and closing operation of the valve and an operation of a mass flow controller (MFC) serving as a flow rate controller (flow rate control structure).

The pressure controller 309 is configured to control a process pressure based on the setting value defined (or set) in the recipe and pressure values detected by a pressure sensor (not shown). Specifically, the pressure controller 309 is configured to control a switching operation (on/off operation) of a pressure regulator (which is a pressure adjusting structure) and a switching operation of the vacuum pump (not shown) such that the inner pressure of the process chamber 201 reaches and is maintained at a desired pressure at a desired timing. In the present specification, the term "process pressure" refers to the inner pressure of the process chamber 201.

The drive controller 306 includes controllers (sub-controllers) such as a transfer controller 311, a rotation controller 312 and an elevation controller 313. In addition, while the drive controller 306 and each sub-controller (that is, the transfer controller 311, the rotation controller 312 and the elevation controller 313) are illustrated separately, the drive controller 306 and each sub-controller may be integrated into a single structure.

For example, the transfer controller 311 is configured to control each transfer operation of components such as the boat elevator 115, the pod transfer structure 118 and the wafer transfer structure 125.

For example, the rotation controller 312 is configured to control each rotation operation of components such as the pod transfer structure 118, the wafer transfer structure 125 and a rotating shaft 116 located at a center of the rotatable pod shelf 105.

For example, the elevation controller 313 is configured to control each elevation operation (elevating and lowering operation) of components such as the boat elevator 115, the pod transfer structure 118 and the wafer transfer structure 125.

In addition, according to the present embodiments, each of the control apparatus 100, the process controller 305 and the drive controller 306 may be embodied by a general computer system without being limited to a dedicated computer system. For example, by installing, in the general computer system, a program for executing the predetermined processing described above from a predetermined recording medium such as a CD-ROM and a USB memory storing the program, each controller described above may be provided to perform the predetermined processing.

In addition, a method of supplying the program described above can be appropriately selected. Instead of or in addition to being supplied through the predetermined recording medium as described above, for example, the program may be provided through a communication interface such as a communication line, a communication network and a communication system.

Further, the control apparatus 100 is configured as a computer including the CPU 100a, the RAM 100b, the memory 100c and the I/O port 100d. In the memory 100c, a recipe file such as a recipe in which process procedures and the process conditions for the substrate processing are defined, a control program file for executing the recipe file, a parameter file (setting value file) in which parameters including recipe information for setting the process procedures and the process conditions are defined, an error processing program file, a parameter file for an error processing, various screen files including an input screen to be used to input process parameters and various icon files and the like (which are not shown) are stored (or saved). For example, the control apparatus 100 is electrically connected to a network such as the Internet, a LAN (Local Area Network) and a WAN (Wide Area Network) by using the external communication interface 301, and is configured to be capable of communicating with external apparatuses via the network.

As the memory 100c, for example, a non-volatile memory such as a hard disk drive (HDD), a solid state drive (SSD) and a flash memory may be used.

The memory 100c is configured to store at least the item (or the items) and the setting value (or the setting values) in the step (or the steps) whose flag is set to be valid, among the setting values in the plurality of steps of the recipe. When the memory 100c stores the item and the setting value in the step (steps) whose flag is set to be valid without storing the item and the setting value in the step (steps) whose flag is set to be invalid, it is possible to reduce a file size of the recipe. Thereby, it is possible to suppress (or reduce) consumption of a storage space in the memory 100c.

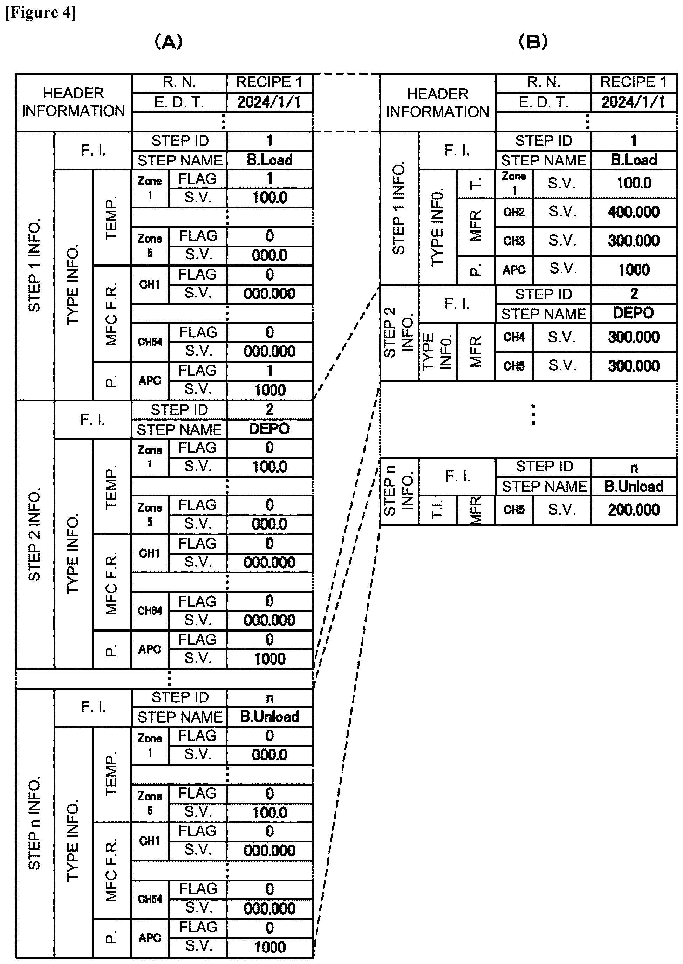

FIG. 4A is a diagram schematically illustrating an example of recipe information temporarily stored in the RAM 100b and used by a recipe editing program. FIG. 4B is a diagram schematically illustrating an example of recipe information stored in the memory 100c and used by the recipe editing program.

As shown in FIG. 4B, the memory 100c stores the recipe information used by the recipe editing program. The recipe information may include header information (which includes a recipe name ("R. N." in FIGS. 4A and 4B) and an editing date and time ("E. D. T." in FIGS. 4A and 4B)) and step information for the plurality of steps. In addition, the step information may include fixed information ("F. I." in FIGS. 4A and 4B) such as a step ID and a step name, as well as type information ("TYPE INFO." in FIGS. 4A and 4B) such as a temperature ("TEMP." or "T." in FIGS. 4A and 4B), a gas flow rate ("MFC F.R." or "MFR" in FIGS. 4A and 4B) and a pressure ("P." in FIGS. 4A and 4B), which serve as the process conditions. The type information may include the item (items) whose flag is set to be valid (set to "1" in FIG. 4A) and information regarding the setting value ("S.V." in FIGS. 4A and 4B) for the item whose flag is set to be valid. The recipe information mentioned above may be stored in the external memory 302.

As shown in FIG. 4A, the RAM 100b temporarily stores the recipe information including the item (items) whose flag is set to be invalid (set to "0" in FIG. 4A) and information on the setting value for the item whose flag is set to be invalid, in addition to the recipe information stored in the memory 100c.

In other words, the CPU 100a loads (or deploys) the recipe in the RAM 100b based on the item whose flag is set to be valid and the setting value therefor stored in the memory 100c. Specifically, the CPU 100a loads the setting value for the item in the step whose flag is set to be valid to become equal to the setting value in a subsequent step whose setting value is not stored in the memory 100c and which comes after the step whose flag is set to be valid. Then, by setting the flag in the subsequent step (whose setting value is loaded in the RAM 100b) to be invalid, the CPU 100a controls the RAM 100b to temporarily store the item and the setting value in each step of the recipe.

In addition, the CPU 100a is further configured to be capable of controlling the display 304 to display, on a screen such as the operation screen, the recipe (which is temporarily stored) including the item whose flag is set to be valid, the setting value for the item whose flag is set to be valid, the item whose flag is set to be invalid and the setting value for the item whose flag is set to be invalid. In other words, the display 304 displays the recipe editing screen 12 including the items and the setting values temporarily stored in the RAM 100b.

For example, a recipe editing processing program and the recipe information may be installed in advance in the substrate processing apparatus 10. The recipe editing program and the recipe information may be implemented by appropriately installing the recipe editing program and the recipe information (which may be recorded on a non-volatile recording medium or may be distributed via the network) in the substrate processing apparatus 10. As the non-volatile recording medium, for example, a component such as a CD-ROM, a magneto-optical disk, a HDD, a DVD-ROM, a flash memory, a memory card and a USB memory may be used.

In other words, the recipe editing processing program is a program (also referred to as a "program product") that causes the substrate processing apparatus 10, by a computer, to perform: (a) editing the recipe constituted by the plurality of steps in which the process conditions for the substrate processing are defined, wherein the process conditions contain at least one item and at least one setting value therefor; and (b) processing the wafer 200 using the recipe edited in (a).

Subsequently, an example of the recipe editing screen 12 according to the present embodiments will be described. FIG. 5 is a diagram schematically illustrating the example of the recipe editing screen 12 displayed on the display 304. The recipe editing screen 12 is controlled by the control apparatus 100 by operating the manipulator 303, and is displayed on the display 304.

The recipe editing screen 12 is configured to be capable of editing the process procedures (steps) in a part of a manufacturing process of a semiconductor device, a plurality of items serving as the process conditions for each process procedure and a plurality of setting values for the plurality of items for each process procedure. In the present specification, the term "edit" may include "adding" or "deleting" a process procedure, "adding" or "deleting" an item, "inputting", "copying", "pasting", "changing" or "deleting" a setting value serving as a parameter for each item in each process procedure, and "switching" (or "toggling") a flag for each item.

In the manufacturing process of the semiconductor device, many process procedures are provided, and many items are set for each process procedure. Therefore, when the setting values for the items in each process procedure on the recipe editing screen 12 are to be stored in the memory 100c, a large amount of storage capacity is to be used to store the recipe.

According to the present embodiments, among the setting values in the plurality of steps of the recipe, at least the item (or the items) and the setting value (or the setting values) in the step (or the steps) whose flag is set to be valid are stored in the memory 100c. When loading the recipe in the RAM 100b based on the items and the setting values stored in the memory 100c, the CPU 100a loads the setting value for the item in the step whose flag is set to be valid to become equal to the setting value in the subsequent step whose setting value is not stored in the memory 100c and which comes after the step whose flag is set to be valid. Then, by setting the flag in the subsequent step (whose setting value is loaded) to be invalid, the CPU 100a is configured to be capable of controlling the RAM 100b to temporarily store the setting value in each step of the recipe. In addition, the CPU 100a is configured to be capable of controlling the display 304 to display, on the recipe editing screen 12, the recipe containing the setting value temporarily stored.

That is, when loading the recipe into the RAM 100b, the CPU 100a is configured to be capable of controlling the display 304 to display the entire items and the entire setting values using the recipe information loaded in the RAM 100b. In other words, when loading the recipe into the RAM 100b, by complementing the item and the setting value (which are not stored in the memory 100c) in the RAM 100b based on the item and the setting value stored in the memory 100c, the CPU 100a is configured to be capable of controlling the display 304 to display the entire items and the entire setting values in the entire steps by using the recipe information loaded in the RAM 100b. As a result, it is possible to easily perform an operation (such as an editing operation) on the recipe editing screen 12, while suppressing (or reducing) consumption of the storage capacity in the memory 100c.

The recipe editing screen 12 may include a recipe display area 13, a setting value display area 14, an "ESC" key 15 and a "SAVE" key 16 serving as a save button.

The recipe display area 13 is configured to display the recipe name and an execution time of the recipe ("E. T OF RECIPE" in FIG. 5). Thereby, it is possible for a user to grasp (or understand) contents of the recipe and the execution time of the recipe on the recipe editing screen 12.

The setting value display area 14 is configured to display the recipe constituted by the plurality of steps in which the process conditions for the wafer 200 are defined. As described above, the process conditions may include at least one item and at least one setting value therefor. For example, the setting value display area 14 is configured as a table where the steps are defined as a vertical axis (Y-axis, also referred to as "columns") and the items constituting the conditions for each step are defined as a horizontal axis (X-axis, also referred to as "rows"). The setting value (which is editable) and the flag (that is, the state of the flag such as "ON" and "OFF") are displayed at an intersection of the two axes.

The process conditions are constituted by at least one type among the temperature, the gas flow rate and the pressure, and each type contains at least one item. In addition, each item includes at least one setting value. Specifically, as shown in FIG. 5, the recipe editing screen 12 displays the setting value and the flag for each item in separate areas for each type. In other words, the CPU 100a is configured to be capable of controlling the display 304 such that each item is displayed in the recipe in separate areas for each type. In a manner described above, various items can be referenced on the recipe editing screen 12. As a result, it is possible to improve a work efficiency.

For example, when storing the recipe in the memory 100c (that is, when the "SAVE" key 16 on the recipe editing screen 12 is pressed), the CPU 100a checks the flag in each step. When a flag for an item in a specified step is set to be valid, the CPU 100a compares a setting value in the specified step with a setting value in a most recent preceding step whose flag is set to be valid among the steps preceding the specified step. Then, when the setting value in the specified step is equal to the setting value in the most recent preceding step, the CPU 100a is configured to be capable of switching (or toggling) the flag for the item in the specified step to invalid.

Then, the CPU 100a stores, in the memory 100c, the item and the setting value in the step whose flag is set to be valid, among the setting values in the plurality of steps of the recipe. In other words, the CPU 100a does not store in the memory 100c the items and setting values in steps whose flags are set to be invalid, among the setting values in the plurality of steps of the recipe. Therefore, it is possible to reduce the file size of the recipe when storing the recipe. As a result, it is possible to suppress (or reduce) the consumption of the storage capacity.

Specifically, as shown in FIG. 5, for example, a flag for "Temp Zone 1" in "Step 8" on the recipe editing screen 12 is set to be "ON". In such a case, the CPU 100a compares a setting value "200.0" for "Temp Zone 1" in "Step 8" with a setting value "200.0" for "Temp Zone 1" in "Step 5" which is the most recent preceding step whose flag is set to be valid. Since the setting value "200.0" for "Temp Zone 1" in "Step 8" is equal to the setting value "200.0" for "Temp Zone 1" in "Step 5", the CPU 100a switches the flag for "Temp Zone 1" in "Step 8" to "OFF". In addition, the CPU 100a is configured to be capable of controlling the memory 100c such that the setting value "200.0" for "Temp Zone 1" in "Step 8" is not stored in the memory 100c.

For example, when a setting value in a specified step is edited on the recipe editing screen 12 by operating the manipulator 303, the CPU 100a checks a setting value in the most recent preceding step whose flag is set to be valid. Then, when the setting value in the specified step edited by the manipulator 303 is equal to the setting value in the most recent preceding step, the CPU 100a is configured to be capable of controlling the display 304 to notify whether to set a flag for the setting value in the specified step to be valid.

Specifically, a message such as "The edited setting value will become the same as the setting value in the most recent preceding step. Do you want to set the flag for the edited setting value to be valid or invalid?" is displayed on the display 304. By notifying an operator (worker) of a change in the flag in a manner described above, it is possible to confirm (or check) the operator's intention, and it is also possible to avoid a decrease in a work efficiency.

For example, when the setting value in the specified step is edited on the recipe editing screen 12 by operating the manipulator 303, the CPU 100a is configured to be capable of controlling the display 304 to display a message confirming the change in the flag. Specifically, when the setting value in the specified step edited by the manipulator 303 is equal to the setting value in the most recent preceding step whose flag is set to be valid among the steps preceding the specified step, for example, a message such as "The edited setting value is the same as the most recent preceding step. Do you want to switch the flag to invalid?" is displayed on the display 304. Thereby, it is possible to avoid (or prevent) an erroneous operation caused by an unintentional switching by the operator.

For example, when a flag in a step is switched from valid to invalid by operating the manipulator 303, the CPU 100a is configured to be capable of changing a setting value in each step after the switched step (i.e., the step whose flag is switched to invalid) and before a next valid step (i.e., a step which comes after the switched step and whose setting value is set to be valid) to become equal to a setting value in the most recent preceding step whose flag is set to be valid among the steps preceding the step whose flag is switched to invalid. In other words, when the flag in the step is switched from valid to invalid, the setting value in each step after the switched step and before the next valid step can be automatically changed to the setting value in the most recent preceding step whose flag is set to be valid among the steps preceding the step whose flag is switched to invalid.

Specifically, for example, when a setting value for "Temp Zone 1" in "Step 5" on the recipe editing screen 12 shown in FIG. 5 is changed from "200.0" to "100.0," a setting value for "Temp Zone 1" after a change in "Step 5" becomes equal to a setting value for "Temp Zone 1" in "Step 1" which is the most recent preceding step whose flag is set to be valid among the steps preceding "Step 5". Therefore, a flag for "Temp Zone 1" in "Step 5" is switched from "ON" to "OFF." Then, a setting value in each step after "Step 5" and before "Step 8" (which comes after the "Step 5" and whose setting value is set to be valid) is changed to "100.0," which is the setting value in "Step 1".

For example, there may be a case where a command (that is, an execution condition) is set at a specified step. In this case, even when a setting value in the specified step is equal to a setting value in the most recent preceding step whose flag is set to be valid among the steps preceding the specified step, the CPU 100a is configured to be capable of not switching the flag in the specified step to invalid. As the execution condition, for example, a command "Sub Call" to call another recipe, a command "Jump" to jump to a different step, or a command "Loop" to repeatedly perform predetermined steps may be used. As a result, it is possible to avoid affecting other steps.

Specifically, for example, when a setting value for "MFC CH2" in "Step 7" on the recipe editing screen 12 shown in FIG. 5 is changed from "300.0" to "400.0", a setting value for "MFC CH2" after a change in "Step 7" becomes equal to the setting value for "MFC CH2" in "Step 1" which is the most recent preceding step whose flag is set to be valid among the steps preceding "Step 7". However, because the command "Loop" is set in "Step 7", a flag for the "MFC CH2" in "Step 7" is not changed from "ON" to "OFF."

The "SAVE" key 16 is configured to save (or store) the recipe in the memory 100c when pressed. In addition, the CPU 100a is configured to be capable of checking whether the flag (that is, the state of the flag) is valid or invalid by operating the "SAVE" key 16. Thereby, it is possible to clarify a timing for checking the flag (that is, the state of the flag), and it is also possible to reduce the load on the CPU 100a when editing the recipe.

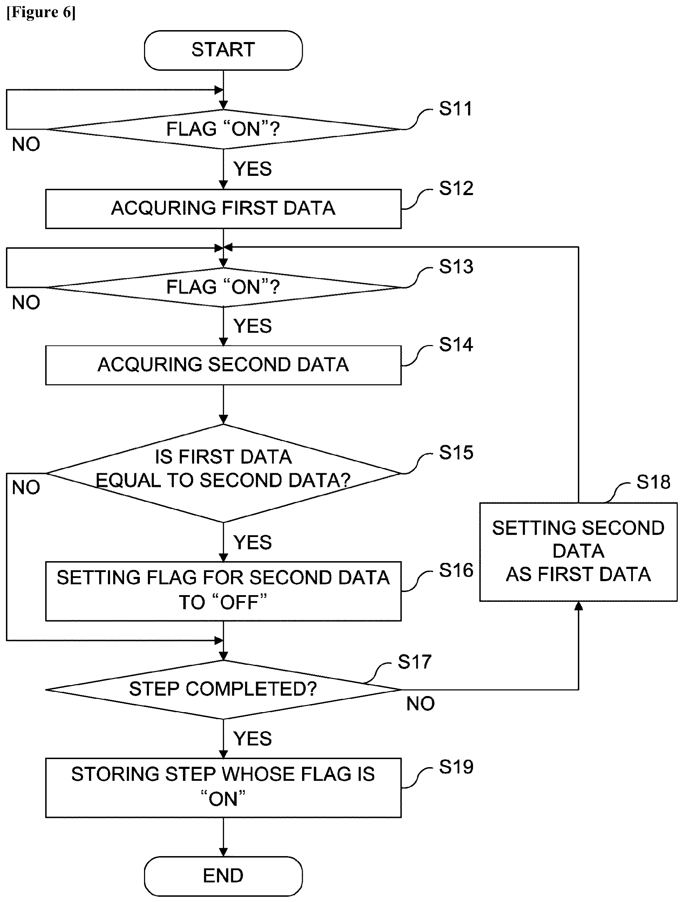

Subsequently, an example of a flag switching process according to the present embodiments will be described with reference to FIGS. 5 and 6. The display 304 is configured to display, on the recipe editing screen 12, the recipe constituted by the plurality of steps in which the process conditions for the substrate processing are defined. As described above, for example, the process conditions may include at least one item and at least one setting value therefor.

First, in a step S11, the CPU 100a checks the flag (the state of the flag) for the setting value for each item sequentially starting from the initial step of the plurality of steps. Specifically, starting from "Step 1", the CPU 100a checks the flag for the setting value for each item and determines whether the flag is valid (that is, "ON" or "1"). When it is determined that the flag is set to be valid (that is, "ON" or "1"), the flag switching process proceeds to a step S12. When it is determined that the flag is set to be invalid (that is, "OFF" or "0"), the flag switching process returns to the step S11, and the CPU 100a checks the flag for the setting value for each item in a subsequent step among the plurality of steps.

Subsequently, in the step S12, the CPU 100a acquires, as first data, the setting value for each item whose flag is set to be valid (that is, "ON" or "1") in each step. Specifically, for example, the setting value "100.0" for the item "Temp Zone 1" whose flag is set to be "ON" in "Step 1" is acquired as the first data.

Subsequently, in a step S13, the CPU 100a checks the flag (the state of the flag) for the setting value for each item in a subsequent step. Specifically, for example, the CPU 100a checks the flag (the state of the flag) for each item in "Step 2" which comes after the "Step 1" where the first data is acquired, and determines whether the flag is set to be valid (that is, "ON" or "1"). When it is determined that the flag is set to be valid (that is, "ON" or "1"), the flag switching process proceeds to a step S14. When it is determined that the flag is set to be invalid (that is, "OFF" or "0"), the flag switching process returns to the step S13, and the CPU 100a checks the flag for the setting value for each item in a subsequent step.

Subsequently, in the step S14, the CPU 100a acquires, as second data, the setting value for each item in a next valid step whose flag is set to be valid (that is, "ON" or "1"). In other words, the CPU 100a acquires, as the second data, the setting value in another step which is the first subsequent step whose flag is set to be valid after the step whose setting value is acquired as the first data. Specifically, for example, the setting value "200.0" for the item "Temp Zone1" in "Step 5", which is the first subsequent step whose flag is set to "ON" following the "Step 1" whose flag is set to "ON", is acquired as the second data.

Subsequently, in a step S15, the CPU 100a compares the first data with the second data to determine whether the first data is equal to the second data. When the first data is equal to the second data, the flag switching process proceeds to a step S16, and when the first data is different from the second data, the flag switching process proceeds to a step S17. Specifically, the setting value "100.0" for the item "Temp Zone1" in "Step 1" is compared with the setting value "200.0" for the item "Temp Zone1" in "Step 5". Since the setting values are different from each other, the flag switching process proceeds to the step S17.

Subsequently, in the step S16, when the first data is equal to the second data, the CPU 100a switches the flag in the step whose setting value is acquired as the second data to invalid.

Specifically, the setting value "200.0" for "Temp Zone1" in "Step 5" is newly set as the first data, and the setting value "200.0" whose flag is set to ON for the item "Temp Zone1" in "Step 8" which comes after the "Step 5" (whose setting value is newly set as the first data) is newly acquired as the second data. Then, since the setting value "200.0" for the item "Temp Zone1" in "Step 8" is equal to the setting value "200.0" for "Temp Zone1" in "Step 5", the flag for "Temp Zone1" in "Step 8" is switched to "OFF".

In other words, CPU 100a checks the flag for each item in each step. When the flag in the specified step is set to be valid, the CPU 100a compares the setting value in the specified step with the setting value in the most recent preceding step whose flag is set to be valid. Then, when the setting value in the specified step is equal to the setting value in the most recent preceding step, the CPU 100a switches the flag in the specified step to invalid.

In such an operation, the CPU 100a is configured to be capable of not switching the flag in the specified step to invalid when the execution condition such as the command "Sub Call", the command "Jump" and the command "Loop" is set for the specified step. As a result, it is possible to avoid affecting other steps.

Subsequently, in the step S17, the CPU 100a determines whether the flag is checked for the entire items in the entire steps. That is, the CPU 100a determines whether a flag checking operation is completed for the entire items in the entire steps. When it is determined that the flag checking operation is completed for the entire items in the entire steps, the flag switching process proceeds to a step S19. When it is determined that the flag checking operation is not completed for the entire items in the entire steps, the flag switching process proceeds to a step S18.

Subsequently, in the step S18, the CPU 100a newly sets the second data as the first data and returns to the step S13 again. That is, the CPU 100a acquires, as the second data, the setting value in a subsequent step whose flag is set to "ON". Thereby, it is possible to efficiently compare the setting values in subsequent steps.

In other words, when the flag checking operation is not completed for the entire items in the entire steps, the CPU 100a newly sets the second data as the first data, and then acquires, as the second data, the setting value in the subsequent step whose flag is set to "ON".

Then, in the step S19, the CPU 100a stores, in the memory 100c, the item (items) and the setting value (setting values) in the step (steps) whose flag is set to be valid among the plurality of items and the plurality of setting values in the plurality of steps, and the flag switching process is completed. In other words, the CPU 100a does not store, in the memory 100c, the item (items) and the setting value (setting values) in the step (steps) whose flag is set to be invalid among the plurality of items and the plurality of setting values in the plurality of steps.

In addition, when loading the recipe into the RAM 100b, the CPU 100a loads the setting value in the step whose flag is set to be valid to become equal to the setting value in the subsequent step whose setting value is not stored in the memory 100c which comes after the step whose flag is set to be valid. Then, the CPU 100a sets the flag in the subsequent step to be invalid. Thereby, the CPU 100a temporarily stores the setting value in each step in the recipe in the RAM 100b, and displays, on the screen, the recipe including the setting values temporarily stored in the RAM 100b.

As a result, it is possible to easily perform the operation on the recipe editing screen 12 while suppressing (or reducing) the consumption of the storage capacity in the memory 100c.

The invention may be summarized as follows: It is possible to save storage capacity by reducing a file size of a recipe. There is provided a technique that includes: a display for a recipe constituted by steps including process conditions containing at least one item and at least one setting value therefor; a controller for: checking, for each step, a flag indicating whether a setting value is to be stored; and when a flag in a specified step is set to be valid, comparing a setting value in the specified step with a setting value in a most recent preceding step whose flag is set to be valid; and switching the flag in the specified step to invalid when it is equal to the setting value in the most recent preceding step; and a first memory storing at least an item and a setting value therefor in a step whose flag is set to be valid.

For example, the embodiments mentioned above are described by way of an example in which the substrate processing apparatus 10 is used. However, the technique of the present disclosure may also be applied to a program that causes a computer to perform the functions of the substrate processing apparatus 10. Further, the technique of the present disclosure may also be applied to a non-transitory computer-readable recording medium storing the program that causes the computer to perform the functions of the substrate processing apparatus 10.

For example, the configuration of the substrate processing apparatus 10 described in the embodiments mentioned above is merely an example, and may be changed in accordance with circumstances without departing from the scope of the technique of the present disclosure.

For example, the process flow of the program described in the embodiments mentioned above is merely an example, and may be changed. For example, an unnecessary step may be deleted, a new step may be added, or the process procedures may be changed without departing from the scope of the technique of the present disclosure.

For example, the embodiments mentioned above are described by way of an example in which the processing according to the embodiments is implemented by a software configuration that uses the computer to execute the program. However, the technique of the present disclosure is not limited thereto. For example, the technique of the present disclosure may also be applied to a hardware configuration capable of performing the processing, or may also be applied to a combination of hardware and software configurations capable of performing the processing.

For example, the embodiments mentioned above are described by way of an example in which a batch type substrate processing apparatus capable of simultaneously processing a plurality of substrates is used to form a film. However, the technique of the present disclosure is not limited thereto. For example, the technique of the present disclosure may also be preferably applied when a single wafer type substrate processing apparatus capable of processing one or several substrates at a time is used to form the film. In addition, the embodiments mentioned above are described by way of an example in which a substrate processing apparatus including a hot wall type process furnace is used to form the film. However, the technique of the present disclosure is not limited thereto. For example, the technique of the present disclosure may also be preferably applied when a substrate processing apparatus including a cold wall type process furnace is used to form the film.

The process procedures and the process conditions for each process using the substrate processing apparatuses exemplified above may be substantially the same as those of the embodiments mentioned above. Even in such a case, it is possible to obtain substantially the same effects as in the embodiments mentioned above.

### [Description of Reference Numerals]

200: Wafer (Substrate)
10: Substrate Processing Apparatus (Processing Apparatus)
12: Recipe Editing Screen (Screen)
100a: CPU (Controller)
100c: Memory Unit (First Memory)
304: Display

## Claims

1. A processing apparatus comprising:
a display configured to be capable of displaying, on a screen, a recipe constituted by a plurality of steps in which process conditions for a substrate processing are defined, wherein the process conditions contain at least one item and at least one setting value therefor;
a controller configured to be capable of:
checking, for each of the plurality of steps, a flag indicating whether a setting value in each step is to be stored; and
when a flag in a specified step is set to be valid, comparing a setting value in the specified step with a setting value in a most recent preceding step whose flag is set to be valid; and
switching the flag in the specified step to invalid when the setting value in the specified step is equal to the setting value in the most recent preceding step; and
a first memory configured to store at least an item and a setting value therefor in a step whose flag is set to be valid, among setting values in the plurality of steps.

2. The processing apparatus of claim 1, wherein the controller is further configured to be capable of:
when loading the recipe into a second memory based on the setting value stored in the first memory, temporarily storing the setting value in each step in the recipe in the second memory by loading the setting value in the step whose flag is set to be valid to become equal to a setting value in a subsequent step whose setting value is not stored in the first memory and coming after the step whose flag is set to be valid, and setting a flag in the subsequent step to be invalid; and
controlling the display to display, on the screen, the recipe containing the setting value in each step temporarily stored.

3. The processing apparatus of claim 1 and/or 2, wherein the process conditions are constituted by at least one type among a temperature, a gas flow rate and a pressure, and each type contains at least one item, and each item comprises at least one setting value, and
wherein the controller is further configured to be capable of controlling the display such that each item is displayed in the recipe in separate areas for each type.

4. The processing apparatus of any one or more of claims 1 to 3, further comprising
a manipulator configured to be capable of editing the recipe displayed on the display,
wherein the controller is further configured to be capable of controlling the display to switch a displayed image of a setting value in the recipe edited by operating the manipulator, and
wherein the controller is further configured to be capable of:
temporarily storing the setting value in each step in the recipe in a second memory by: (a) switching a flag for the setting value edited by operating the manipulator in accordance with the setting value in the recipe edited by operating the manipulator; and (b) changing a setting value in each subsequent step after a step whose flag is switched and before a subsequent valid step whose setting value is set to be valid after the step whose flag is switched to become equal to the setting value edited by operating the manipulator and setting a flag in aforementioned each subsequent step to be invalid; and
controlling the display to display, on the screen, the recipe containing the setting value in each step temporarily stored.

5. The processing apparatus of any one or more of claims 1 to 4, wherein the controller is further configured to be capable of:
acquiring the setting value in the step whose flag is set to be valid as first data sequentially starting from an initial step of the plurality of steps;
acquiring a setting value in a subsequent step thereof whose flag is set to be valid as second data; and
switching the flag in the subsequent step to invalid when the first data is equal to the second data.

6. The processing apparatus of claim 5, wherein the controller is further configured to be capable of:
when the first data is different from the second data, setting the second data as a new first data; and
acquiring a setting value in another step which comes after the subsequent step and whose flag is set to be valid as a new second data.

7. The processing apparatus of any one or more of claims 1 to 6, wherein the controller is further configured to be capable of controlling the first memory such that a setting value in a step whose flag is set to be invalid is not stored in the first memory.

8. The processing apparatus of any one or more of claims 1 to 7, wherein, even when the setting value in the specified step is equal to the setting value in the most recent preceding step, the controller is further configured to be capable of not switching the flag in the specified step to invalid when an execution condition is set at the specified step.

9. The processing apparatus of any one or more of claims 1 to 8, further comprising
a save button configured to store the recipe in the first memory,
wherein the controller is further configured to be capable of checking a state of the flag by operating the save button.

10. The processing apparatus of any one or more of claims 1 to 9, wherein the controller is further configured to be capable of:
when a setting value in a step in the recipe is edited by operating a manipulator, checking a setting value in a previous valid step whose flag is set to be valid and which comes most recently before the step whose setting value is edited among all previous valid steps; and
when the setting value edited by operating the manipulator is equal to the setting value in the previous valid step, controlling the display to notify whether to set the flag for the setting value edited by operating the manipulator to valid.

11. The processing apparatus of any one or more of claims 1 to 10, wherein the first memory is configured not to store the flag.

12. A substrate processing apparatus comprising:
the processing apparatus of any one or more of claims 1 to 11; and
a process vessel in which a substrate is processed in accordance with the process conditions of the recipe of any one or more of claims 1 to 11.

13. A processing method comprising:
(a) displaying, on a screen, a recipe constituted by a plurality of steps in which process conditions for a substrate processing are defined, wherein the process conditions contain at least one item and at least one setting value therefor;
(b) performing:
(b-1) checking, for each of the plurality of steps, a flag indicating whether a setting value in each step is to be stored;
(b-2) when a flag in a specified step is set to be valid, comparing a setting value in the specified step with a setting value in a most recent preceding step whose flag is set to be valid; and
(b-3) switching the flag in the specified step to invalid when the setting value in the specified step is equal to the setting value in the most recent preceding step; and
(c) storing at least an item and a setting value therefor in a step whose flag is set to be valid, among setting values in the plurality of steps.

14. A method of manufacturing a semiconductor device, comprising
the method of claim 13; and
processing a substrate in accordance with the process conditions of the recipe of claim 13.

15. A program that causes a substrate processing apparatus, by a computer, to perform:
(a) displaying, on a screen, a recipe constituted by a plurality of steps in which process conditions for a substrate processing are defined, wherein the process conditions contain at least one item and at least one setting value in the at least one item;
(b) performing:
(b-1) checking, for each of the plurality of steps, a flag indicating whether a setting value in each step is to be stored;
(b-2) when a flag in a specified step is set to be valid, comparing a setting value in the specified step with a setting value in a most recent preceding step whose flag is set to be valid; and
(b-3) switching the flag in the specified step to invalid when the setting value in the specified step is equal to the setting value in the preceding step; and
(c) storing at least an item and a setting value therefor in a step whose flag is set to be valid, among setting values in the plurality of steps.
